# FASCICULE DE BREVET EUROPEEN

(11) **EP 1 151 384 B1**
(45) Date de publication et mention de la délivrance du brevet: **08.07.2009**
(21) Numéro de dépôt: 99961124.7
(22) Date de dépôt: 21.12.1999
(51) Int. Cl.: G06F 12/02, G11C 16/22

(54) **SYSTEME DE MEMORISATION COMPRENANT DES MOYENS DE GESTION D'UNE MEMOIRE AVEC ANTI-USURE ET PROCEDE DE GESTION ANTI- USURE D'UNE MEMOIRE**
SPEICHERUNGSSYSTEM MIT MITTELN ZUR SPEICHERVERWALTUNG MIT VERSCHLEISSSCHUTZ UND VERFAHREN ZUR SPEICHERVERWALTUNG MIT VERSCHLEISSSCHUTZ
STORAGE SYSTEM COMPRISING MEANS MANAGING A STORAGE UNIT WITH ANTI-WEAR AND ANTI-WEAR MANAGEMENT OF A STORAGE UNIT

(30) Priorité: 22.12.1998 FR 9816216
(43) Date de publication de la demande: 07.11.2001
(73) Titulaire: Gemalto SA, 92190 Meudon (FR)
(72) Inventeur: GUTERMAN, Pascal, F-13360 Roquevaire (FR)
(86) Numéro de dépôt international: PCT/FR1999/003222
(87) Numéro de publication internationale: WO 2000/038067

(56) Documents cités:
- FR-A- 2 712 412
- GB-A- 2 291 991

## Description

L'invention concerne un système de mémorisation comprenant au moins une mémoire et des moyens de gestion de ladite mémoire avec anti-usure de manière à augmenter la durée de vie de ladite mémoire.

L'invention concerne également un procédé de gestion anti-usure d'une telle mémoire.

L'invention s'applique à toute mémoire non volatile ou dont le contenu est sauvegardé, susceptible d'avoir des mises à jour fréquentes de certaines données.

L'invention s'applique notamment à des supports de mémorisation tels que les cartes à puce.

Les fabricants de mémoires de type EPROM, EEPROM, FeRAM savent que quelle que soit la technologie des mémoires non volatiles, il existe un nombre maximal N d'écritures-lectures possibles pour chaque cellule constituant une mémoire.

On considère en effet qu'une mémoire est usée dès que le nombre d'écritures et/ou de lectures a atteint ce nombre maximal N. C'est-à-dire qu'au delà de ce nombre il y a un risque d'altération des informations, voire de perte des données que l'on pourrait écrire dans la mémoire.

On cherche, selon l'invention à diminuer l'usure des cellules mémoires non volatiles dans lesquelles on est amené à effectuer de nombreux accès en écriture (cas des mémoires EPROM ou EEPROM) ou en lecture (cas des mémoires FeRAM), pour certaines données.

On a cherché traditionnellement à résoudre ce problème, en isolant les données considérées comme sensibles, c'est-à-dire les données qui sont mises à jour souvent, dans une partie réservée à cette fin dans la mémoire.

Malheureusement il y a une fatigue des zones concernées qui se produit du fait de ces mises à jour effectuées toujours pour les mêmes données et donc toujours pour les mêmes cellules mémoires.

On a cherché à résoudre ce problème en divisant la partie réservée en deux ou plusieurs zones, de manière à mettre en oeuvre un dispositif de répartition d'usure des informations lors des écritures successives des nouvelles données. Ceci permet d'éviter la perte d'information due à une usure des cellules mémoire dédiées aux informations. En pratique, la ou les données précédentes à la nouvelle donnée sont conservées dans la ou les zones dédiées.

Le document GB-A-2 291 991 divulge les caractéristiques du préambule des revendications 1 et 6.

Cependant aucune solution proposée à ce jour n'est suffisamment satisfaisante. En d'autres termes, aucune solution ne rallonge de manière significative la durée de vie d'une telle mémoire.

Un but de la présente invention est de résoudre ce problème.

Un autre but de l'invention est d'apporter une solution à l'usure des mémoires y compris dans les cas où l'on ne sait pas a priori quelles seront les cellules mémoires qui seront stressées. Ceci sera de plus en plus le cas avec la possibilité qui est offerte de charger dans les cartes des programmes interprétables (le programme est constitué de données en langage interprétable). Les chargements de programmes interprétables pourront être des téléchargements effectués par les utilisateurs eux-mêmes. Lesdits programmes pourront être développés sans tenir compte de la répartition de l'usure des cellules mémoires. Celle-ci sera directement prise en compte par des moyens de gestion de la mémoire de la carte selon l'invention.

Un autre but de l'invention est d'apporter une solution à l'espionnage des données sensibles, puisque comme on va le voir de manière détaillée, ces données vont être déplacées dans la mémoire.

L'invention a pour premier objet un système de mémorisation comprenant au moins une mémoire non volatile contenant des informations susceptibles d'être mises à jour, principalement caractérisé en ce qu'il comporte des moyens de gestion de cette mémoire aptes à déplacer sur toute ou partie de la mémoire respectivement tout ou partie du contenu de ladite mémoire.

En pratique tout le contenu de la mémoire sera déplacé avec comme exception des données qui seraient dans cette mémoire et pour lesquelles il est impératif de maintenir l'adresse physique. C'est par exemple le cas des données de gestion (et/ou instructions) du mécanisme mis en oeuvre par les moyens de gestion selon l'invention. Si ces données sont stockées dans cette mémoire, alors la partie mémoire contenant toutes ces données (et/ou instructions) ne sera pas déplacée.

Dans l'exemple des cartes à puce cela peut aussi être le cas des données telles que le numéro de série de la carte, ou des verrous logiques.

Dans le cas où toutes ces données seraient dans une autre mémoire de la carte, alors tout le contenu de la mémoire gérée sera déplacé.

Les moyens de gestion de la mémoire sont aptes à réaliser des déplacements de manière itérative.

Les déplacements réalisés de manière itérative sont cycliques.

Les moyens pour déplacer comportent :
- des moyens de transfert d'une première région vers une deuxième région,
- des moyens de conversion d'adresse de manière à ce que toutes les demandes d'accès à la première région soient converties en demande d'accès à la deuxième région dans laquelle le contenu de la première région à été transféré.

Les moyens pour déplacer, opèrent par décalage progressif le contenu d'une première région vers une deuxième région.

Selon l'invention, la mémoire est organisée en régions comprenant une ou plusieurs cellules, l'une au moins des régions est vide et les moyens de gestion opèrent des décalages progressifs du contenu d'une première région vers une deuxième région ladite deuxième région étant la région vide ou vidée lors d'un décalage précédent.

Les moyens pour déplacer par décalage progressif le contenu d'une première région vers une deuxième région vide ou vidée comportent en outre des moyens de commande du décalage.

Les moyens de commande du décalage sont réalisés par un signal d'horloge.

Les moyens de commande du décalage sont réalisés par un signal de commande à caractère aléatoire.

Les moyens de commande du décalage comportent des moyens de comptage de comparaison du nombre d'accès à la mémoire par rapport à un seuil prédéterminé .

Les moyens de transfert comportent un programme de lecture de toute la première région concernée et d'écriture dans la deuxième région concernée.

Les moyens de conversion d'adresse comportent une unité logique réalisée par un programme.

Les moyens de conversion d'adresse comportent une unité physique réalisée par un circuit logique dans le circuit d'adressage de la mémoire.

Dans une application particulière de l'invention, le système de mémorisation est constitué d'une carte à puce.

Un autre objet de l'invention est un procédé de gestion d'une mémoire non volatile contenant des informations susceptibles d'être mises à jour, principalement caractérisé en ce qu'il comporte une étape de déplacement sur toute ou partie de la mémoire respectivement de tout ou partie du contenu de ladite mémoire.

Selon un mode préféré de réalisation, la mémoire est organisée en régions, et l'étape de déplacement comprend des étapes de transfert du contenu des régions.

Le procédé comporte l'étape de :
- prévoir au moins une région libre dans ladite mémoire, les informations destinées à être enregistrées dans ladite mémoire étant enregistrées dans les régions de la mémoire autres que cette région vide.

Selon l'invention, l'étape de déplacement est réalisée par décalage progressif du contenu d'une première région vers une deuxième région, ladite deuxième région étant la région vide ou vidée lors d'un décalage précédent.

Le décalage progressif comporte une étape de:
- repérage de la nouvelle région libre.

L'étape de déplacement comporte en outre une étape de conversion d'adresses de manière à ce que toutes les demandes d'accès à la première région soient converties en demandes d'accès à la deuxième région, dans laquelle le contenu de la première région a été transféré.

L'étape de décalage progressif comporte une étape de commande du décalage.

La commande du décalage est realisée à partir d'un signal d'horloge.

La commande du décalage peut être réalisée par un signal à caractère aléatoire.

Selon un autre mode de réalisation l'étape de commande de décalage comporte un comptage du nombre d'accès à ladite mémoire et une comparaison de ce nombre d'accès à un seuil (S) prédéterminé pour ledit nombre.

L'étape de transfert est réalisée au moyen d'un programme de lecture de toute la première région concernée et d'écriture dans la deuxième région concernée.

D'autres avantages et particularités de l'invention apparaîtront à la lecture de la description ci-jointe qui est faite à titre d'exemple non limitatif et en regard des dessins sur lesquels :
- la figure 1, représente le schéma d'un système de mémorisation selon un premier mode de réalisation,
- la figure 2, représente le schéma d'un système de mémorisation selon un deuxième mode de réalisation,
- la figure 3, représente de façon schématique un plan mémoire illustrant le mécanisme mis en oeuvre par les moyens de gestion conformes à l'invention,
- la figure 4, illustre ce mécanisme à l'issue d'un cycle complet, et
- la figure 5, illustre de manière schématique un moyen de repérage de la région vide conformément à l'invention.

On va décrire maintenant l'invention dans le cadre d'une application particulière où la mémoire non volatile (ou mémoire sauvegardée) contient des données à mettre à jour, et se trouve dans une carte à puce 1.

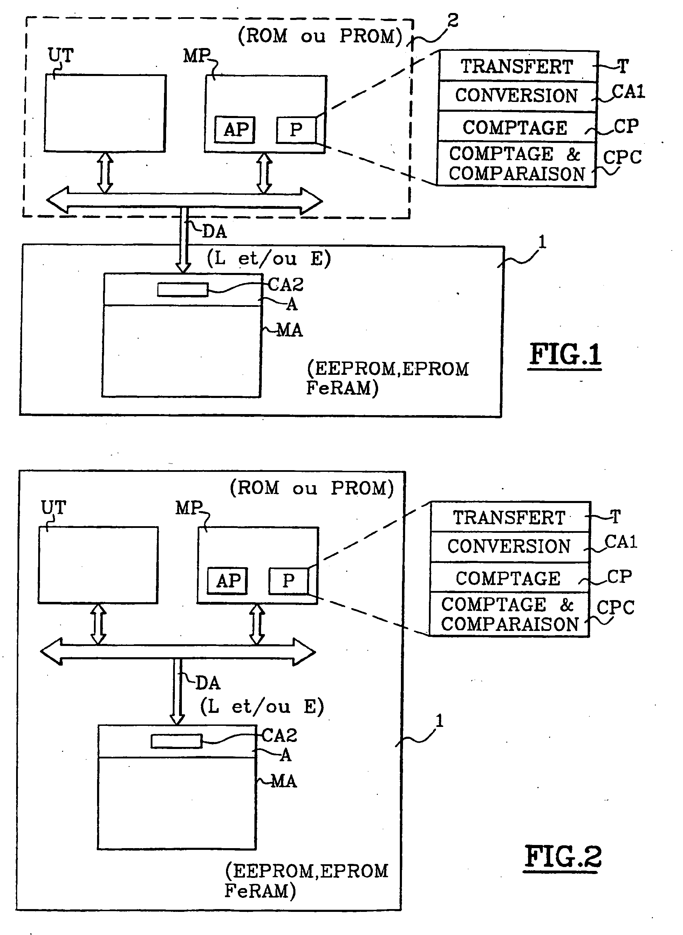

Les schémas des figures 1 et 2 illustrent les deux configurations possibles pour une carte à puce.

Dans la figure 1, la carte à puce 1 comporte seulement une mémoire MA de données (et/ou de programmes interprétables) dont certaines sont susceptibles d'êtres mises à jour. Les moyens de gestion 2 de ladite mémoire MA sont déportés dans ce cas dans le lecteur de carte à puce.

Dans la figure 2, la carte à puce comporte à la fois les moyens de gestion 2 de la mémoire et la mémoire MA elle même.

Ces deux représentations sont classiques. Il existe dans le commerce des cartes à puce qui ne comportent que de la mémoire et des cartes à puce qui comportent un microprocesseur avec sa mémoire de programme et la mémoire servant à la ou aux applications prévues.

L'invention s'applique donc à tout système de mémorisation comprenant des moyens de gestion, que ces moyens de gestion de la mémoire soient sur le même support que la mémoire elle-même, où qu'ils soient déportés par exemple dans un lecteur de cartes à puce.

La figure 1 représente plus particulièrement des moyens de gestion formés par une unité de traitement UT qui sera par exemple un microprocesseur, une mémoire de programme MP (ROM ou PROM) associée à ce microprocesseur MP. Cette mémoire de programme MP comporte généralement un programme d'application AP. Selon l'invention, la mémoire de programme comportera également un programme P permettant de mettre en oeuvre le mécanisme de gestion qui va être décrit dans la suite.

Les moyens de gestion 2 de la mémoire MA de données d'application sont par conséquent constitués par l'unité de traitement UT et au moins une mémoire de programme MP, qui contient le programme P apte à mettre en oeuvre le mécanisme de gestion de cette mémoire MA.

A cette fin, ce programme P contient un sous-programme T de transfert de données, un programme de comptage CPC du nombre N_{AD} d'accès à la mémoire MA et de comparaison dudit nombre d'accès N_{AD} à un seuil prédéterminé S.

Ce programme P peut contenir également un programme de conversion CA1 qui va permettre de faire des conversions d'adresses physiques pour une adresse logique demandée par le programme d'application AP.

Ces moyens de conversion peuvent en fait, également être réalisés directement au niveau de la mémoire MA par un circuit logique câblé CA2 contenu par exemple dans le circuit d'adressage A de la mémoire MA.

En effet, on pourra choisir dans le cas de systèmes existants, de mettre en oeuvre le mécanisme de conversion d'adresses physiques dans un sous-programme CA1 de la mémoire de programme comme on vient de le dire.

Mais on pourra également pour des nouveaux systèmes et des nouvelles mémoires, prévoir au stade de la fabrication, un circuit logique CA2 apte à effectuer ces conversions d'adresses physiques.

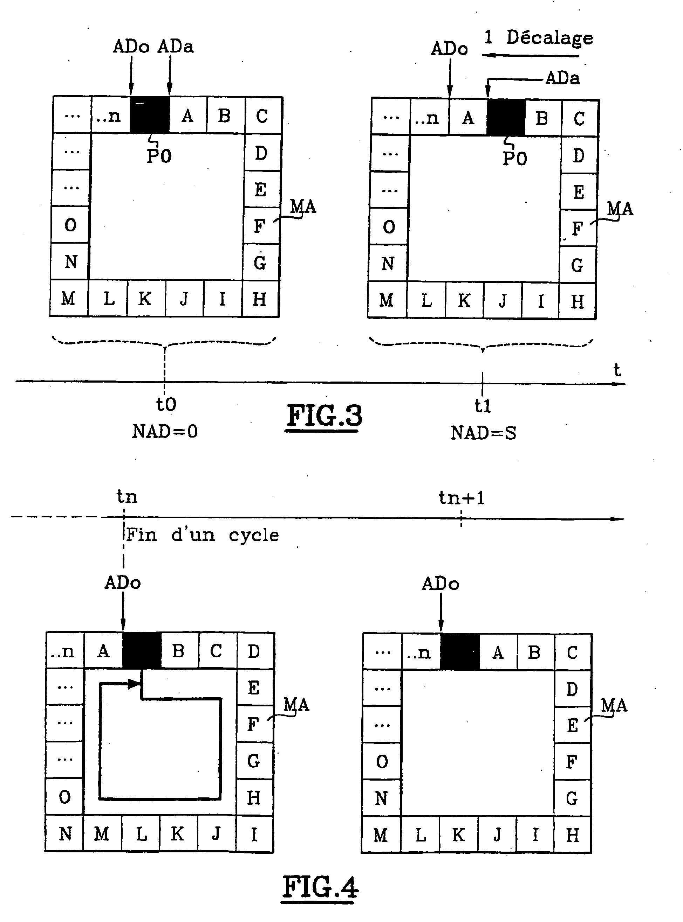

On va illustrer les mécanismes de gestion mis en oeuvre par les moyens de gestion conformes à l'invention, au moyen des figures 3, 4 et 5.

La représentation qui est faite du plan mémoire sous forme de couronne est fictive, elle permet simplement de bien illustrer le mécanisme mis en jeu et qui s'apparente à un jeu de taquin. On va retenir simplement que la mémoire est découpée ou organisée physiquement en régions A, B, C, ... n et, que ces régions peuvent être formées d'une seule cellule mémoire par exemple ou d'un ensemble de cellules selon la technologie de la mémoire utilisée.

A titre d'exemple, dans une mémoire EEPROM, la mémoire est organisée en régions appelées pages, chaque page ayant une taille de plusieurs octets.

Le schéma de la figure 3, illustre deux plans mémoire, un premier plan pris à l'instant To, instant pour lequel le nombre d'accès mémoire N_{AD} est zéro par exemple et, un deuxième plan à l'instant T1, instant pour lequel ce nombre d'accès N_{AD} a atteint le seuil prédéterminé S.

A l'instant To, on peut repérer les régions A, B, C, ... n et une région vide Po. A l'instant T1, on constate que le contenu de la région A est passé dans la région vide Po, la région vide Po étant maintenant celle qui se trouve à l'adresse physique de la région A à l'instant To.

Le mécanisme a permis par conséquent d'effectuer un décalage du contenu de la région A dans la région vide Po. La nouvelle région Po se trouve dans l'ancien emplacement de la région A.

Le mécanisme a permis par conséquent d'opérer un transfert de données de la région A dans la région vide Po.

Ce mécanisme permet en outre vis-à-vis du programme d'application AP faisant des demandes d'accès DA (lectures ou écritures) à des adresses logiques pour des données se trouvant dans la région A, d'opérer une conversion de l'adresse physique (correspondant à l'adresse logique demandée), à l'adresse physique qui est celle qui correspond au nouvel emplacement desdites données dans la région A.

L'ordre d'effectuer un transfert d'une région A à la région vide ou vidée Po est passé par les moyens de gestion, c'est-à-dire par le programme P lorsque le sous-programme de comptage du nombre d'accès N_{AD} a atteint le seuil prédéterminé S.

La figure 4 illustre le mécanisme selon l'invention lorsque l'on a opéré à tous les décalages nécessaires pour obtenir un décalage de toutes les régions de la mémoire. Si le nombre de régions est n le nombre de décalages opérés par les moyens de gestion de la mémoire sera égal à ce nombre n, de manière à ce que tout le contenu de la mémoire ait été transféré d'une région à une autre région en utilisant la région du départ puis la région qui a été vidée à chaque décalage.

Toutes les régions seront ainsi décalées cycliquement.

A titre d'exemple, si l'on a n=100 régions (ou pages) le mécanisme de gestion procédera à 100x100 décalages pour se retrouver au point de départ qui correspond à l'adresse physique origine A_{D0} de la page P₀.

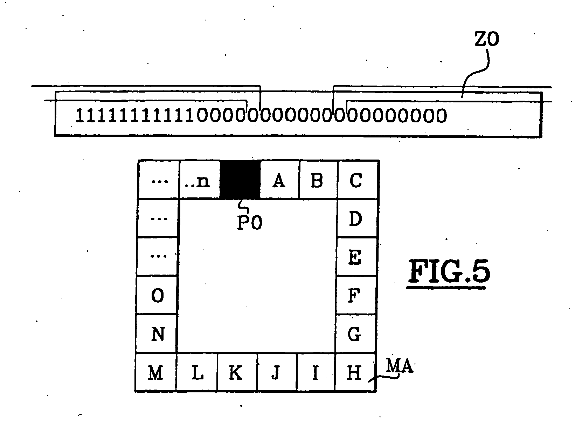

La figure 5 illustre un moyen pour repérer l'emplacement de la région vide Po. Pour réaliser ce repérage, on prévoit une zone Zo qui peut se situer dans une zone fixe de cette mémoire MA réservée à cet effet ou dans une zone mémoire électriquement programmable du système de gestion.

Cette zone a une longueur au moins égale à n bits, n correspondant au nombre de décalages pour opérer un cycle de décalage complet (décalage de toutes les régions).

Le mécanisme selon l'invention permet de mettre un bit à 1 à chaque fois que la région vide Po est déplacée. Cette région Zo permet ainsi de repérer l'emplacement physique de la région vide. Un autre compteur va permettre de compter le nombre de cycles complets de décalages. Ce compteur CP peut être réalisé par le programme P par exemple.

Ainsi, pour toute mémoire ayant un nombre d'accès limité (dû au phénomène de vieillissement), le programme d'application utilisant ladite mémoire pourra faire tous les accès désirés, sans risques grâce aux moyens de gestion qui mettent en oeuvre, le mécanisme qui vient d'être décrit.

Ce mécanisme permet de faire en sorte que les données des régions de la mémoire qui sont les plus souvent modifiées (ou lues) ne soient pas toujours situées dans les mêmes régions, mais qu'elles soient déplacées d'une région à l'autre et ce, pour toutes les régions sans que ces régions aient besoin d'être identifiées.

A un instant donné, les données d'une région sont par exemple au début de la mémoire et progressivement vont glisser vers la fin et recommencer à venir au début.

Le programme d'application fait ses accès en lecture-écriture sans se rendre compte que le lieu physique des données auquel il désire accéder a été changé.

A titre d'exemple, sans le mécanisme de l'invention, si un programme d'application fait des demandes d'accès à une seule cellule mémoire et s'il y accède N=1.000.000 de fois par exemple, il aura détruit la cellule au bout de N fois, la mémoire ne pourra plus être utilisée.

Grâce au mécanisme, le programme va accéder par exemple 1.000.000 de fois à une information, mais cette information aura été déplacée successivement sur 100 cellules par exemple, chaque cellule aura donc été stressée 10.000 fois.

Les régions (les cellules) dans lesquelles sont stockées des données pour lesquelles il y a des mises à jour régulières à faire au cours de la durée de vie de la carte sont plus stressées que les autres par le programme d'application.

L'invention permet donc à un tel programme de ne pas stresser toujours, pour une donnée à mettre à jour, les mêmes cellules ou les mêmes régions. Ledit programme stressera pour cette donnée un autre ensemble de cellules de la mémoire, puis encore un autre ensemble de cellules, etc. L'usure occasionnés par les mises à jour de cette donnée sera par conséquent réparti sur plusieurs ensembles de cellules ou régions.

Les moyens de gestion qui sont mis en oeuvre pour obtenir cette répartition de stress permettent d'avoir une entière transparence vis-à-vis du programme d'application.

Le programme d'application passe ses ordres d'accès (commandes de lecture ou d'écriture) à une adresse logique, les moyens de gestion reçoivent ces commandes et effectuent classiquement la correspondance entre l'adresse physique et l'adresse logique demandée, tant que la donnée n'a pas été transférée à une autre adresse physique.

Les moyens de gestion effectuent une conversion d'adresse physique pour ladite donnée chaque fois qu'aura eu lieu un décalage, c'est-à-dire le transfert du contenu de la région dans laquelle se trouve cette donnée dans une autre région.

## Revendications

1. Système de mémorisation garantissant l'anti-usure d'une mémoire comprenant une mémoire non volatile (MA) contenant des informations susceptibles d'être mises à jour, des moyens de gestions (UT, MP) de cette mémoire, ladite mémoire comprenant des régions (A, B, ... n) de stockage de données destinées à être utilisées successivement en boucle, **caractérisé en ce que** le découpage de la mémoire en régions de stockage de données est indépendant des informations susceptibles d'être enregistrées dans ladite mémoire, **en ce que** la mémoire est organisée en régions (A, B, ... n) dont l'une au moins des régions est vide (Po), les moyens de gestion opérant des décalages progressifs du contenu d'une première région vers une deuxième région, ladite deuxième région état la région vide ou vidée lors du décalage précèdent et **en ce que** les moyens été gestion comportent des moyens de commande de décalage (CP) réalisés à partir d'un signal d'horloge.

2. Système de mémorisation selon la revendication 1 **caractérisé en ce que** les moyens de gestion comportent :
- des moyens de transfert (T) d'une première région vers une deuxième région,
- des moyens de conversion d'adresse (T en A) de manière à ce que toutes les demandes d'accès (DA) à la première région (A) soient converties en demandes d'accès à la deuxième région dans laquelle le contenu de la première région a été transféré.

3. Système de mémorisation selon la revendication 2, **caractérisé en que** les moyens de conversion sont une unité logique réalisée par programme (CA1).

4. Système de mémorisation selon la revendication 2, **caractérisé en que** les moyens de conversion sont une unité physique (CA2) réalisée par un circuit logique dans le circuit d'adressage de la mémoire.

5. Système de mémorisation selon l'une quelconque des revendications précédentes, **caractérisé en ce qu'**il est constitué d'une carte à puce (1).

6. Procédé garantissant l'anti-usure d'une mémoire non volatile (MA) contenant des informations susceptibles d'être mises à jour, ladite mémoire comprenant des régions (A, B, ... n) de stockage de données **caractérisé en ce qu'**il comporte des étapes de déplacement des dites régions sur tout ou partie de la mémoire, de façon indépendante des informations susceptibles d'être enregistrées dans ladite mémoire, **en ce que** les étapes de déplacement des régions sont réalisées par décalage progressif du contenu d'une première région vers une deuxième région, ladite deuxième région étant la région vide ou la région vidée lors d'un décalage précédent et **en ce qu'**il comporte une étape de commande du décalage réalisée à partir d'un signal horloge.

7. Procédé selon la revendication 6 **caractérisé en ce qu'**il comporte une étape de prévoir une région libre (Po) dans la mémoire, les informations destinées à être enregistrées dans ladite mémoire étant enregistrées dans les régions de la mémoire autres que cette région vide.

8. Procédé selon l'une des revendications 6 à 7, **caractérisé en ce qu'**il comporte une étape de repérage de la nouvelle région libre.

9. Procédé selon l'une des revendications 6 à 8, **caractérisé en ce qu'**il comporte en outre à chaque déplacement d'une première région vers une deuxième région, une étape de conversion d'adresses de manière à ce que toutes les demandes d'accès à la première région soient converties en demandes d'accès à la deuxième région.

## Claims

1. A storage system providing the wear resistance of a memory comprising a non volatile memory (MA) containing information liable to be updated, means (UT, MP) for managing such memory, said memory comprising regions (A, B,..., n) for storing data intended to be successively used in a loop, **characterized in that** the partitioning of the memory into data storage regions is independent of the information liable be recorded in said memory, **in that** the memory is organized in regions (A, B,..., n), at least one of the regions of which is empty (Po), the management means carrying out progressive offsets of the contents of a first region towards a second region, said second region being the empty or emptied region during the previous offset and **in that** the management means include offset control means (CP) obtained from a clock signal.

2. A storage system according to claim 1, **characterized in that** the management means include:
- means for transferring (T) a first region to a second region,
- address conversion means (T to A) so that all the requests for access (DA) to the first region (A) are converted into requests for access to the second region, to which the contents of the first region has been transferred.

3. A storage system according to claim 2, **characterized in that** the conversion means are a logical unit obtained from a program (CA1).

4. A storage system according to claim 2, **characterized in that** the conversion means are a physical unit (CA2) obtained from a logical circuit in a memory addressing circuit.

5. A storage system according to any one of the preceding claims, **characterized in that** it is composed of a chip card (1) .

6. A method providing the wear resistance of a non volatile memory (MA) containing information liable to be updated, said memory comprising regions (A, B,..., n) for storing data **characterized in that** it includes steps of moving said regions in the whole or a part of the memory, independently of the information liable to be recorded in said memory, **in that** the steps of moving said regions are obtained through a progressive offset of the contents of a first region to a second region, said second region being the empty region or the emptied region during a previous offset, and **in that** it includes a step of controlling the offset carried out from a clock signal.

7. A method according to claim 6, **characterized in that** it includes a step of providing a free region (Po) in the memory, the information intended to be recorded in said memory being recorded in other regions of the memory than this empty region.

8. A method according to one of claims 6 to 7, **characterized in that** it includes a step of tracing the new free region.

9. A method according to one of claims 6 to 8, **characterized in that** it further includes, upon each motion of a first region to a second region, a step of converting addresses so that all the requests for access to the first region are converted into requests for access to the second region.

## Patentansprüche

1. Speichersystem, das den Verschleißschutz eines Speichers garantiert, der einen nicht flüchtigen Speicher (MA), welcher Informationen enthält, die aktualisiert werden können und Verwaltungsmittel (UT, MP) dieses Speichers umfasst, wobei der genannte Speicher Zonen (A, B, ... n) zur Datenspeicherung umfasst, die dazu bestimmt sind, sukzessive in einer Schleife verwendet zu werden, **dadurch gekennzeichnet, dass** das Zerschneiden des Speichers in Datenspeicherzonen unabhängig von den Informationen ist, die in dem genannten Speicher gespeichert werden können, dass der Speicher in Zonen (A, B, ... n) organisiert ist, von denen wenigstens eine der Zonen (Po) leer ist, wobei die Verwaltungsmittel progressive Verschiebungen des Inhaltes einer ersten Zone zu einer zweiten Zone durchführen, wobei die genannte zweite Zone die leere oder bei der vorherigen Verschiebung geleerte Zone ist und dass die Verwaltungsmittel Verschiebungssteuermittel (CP) umfassen, die ausgehend von einem Uhrsignal realisiert sind.

2. Speichersystem gemäß Anspruch 1, **dadurch gekennzeichnet, dass** die Verwaltungsmittel Folgendes umfassen:
- Transfermittel (T) einer ersten Zone zu einer zweiten Zone,
- Mittel zur Adresskonvertierung (T in A) derart, dass alle Zugangsanfragen (DA) zur ersten Zone (A) in Zugangsanfragen zur zweiten Zone konvertiert werden, in die der Inhalt der ersten Zone transferiert wurde.

3. Speichersystem gemäß Anspruch 2, **dadurch gekennzeichnet, dass** die Konvertierungsmittel eine durch das Programm (CA1) realisierte logische Einheit sind.

4. Speichersystem gemäß Anspruch 2, **dadurch gekennzeichnet, dass** die Konvertierungsmittel eine physische Einheit (CA2) sind, die durch einen logischen Schaltkreis in dem Adressierungsschaltkreis des Speichers realisiert ist.

5. Speichersystem gemäß einem der vorherigen Ansprüche, **dadurch gekennzeichnet, dass** es aus einer Chipkarte (1) gebildet wird.

6. Verfahren, das den Verschleißschutz eines nicht flüchtigen Speichers (MA) garantiert, der Informationen enthält, die aktualisiert werden können, wobei der genannte Speicher Zonen (A, B, ...n) zur Datenspeicherung umfasst, **dadurch gekennzeichnet, dass** es Verschiebungsstufen der genannten Zonen über den gesamten Speicher oder einen Teil davon unabhängig von den Informationen umfasst, die in dem genannten Speicher gespeichert sein können, dass die Verschiebungsstufen der Zonen per progressiver Verschiebung des Inhaltes einer ersten Zone zu einer zweiten Zone realisiert sind, wobei die genannte zweite Zone die leere Zone oder die bei einer vorherigen Verschiebung geleerte Zone ist und dass es eine Steuerstufe der ausgehend von einem Uhrsignal realisierten Verschiebung umfasst.

7. Verfahren gemäß Anspruch 6, **dadurch gekennzeichnet, dass** es eine Stufe zum Vorsehen einer freien Zone (Po) in dem Speicher umfasst, wobei die zum Speichern in dem genannten Speicher bestimmten Informationen in anderen Zonen des Speichers als in dieser leeren Zone gespeichert werden.

8. Verfahren gemäß Anspruch 6 bis 7, **dadurch gekennzeichnet, dass** es eine Kennzeichnungsstufe der neuen freien Zone umfasst.

9. Verfahren gemäß Anspruch 6 bis 8, **dadurch gekennzeichnet, dass** es darüber hinaus bei jeder Verschiebung einer ersten Zone zu einer zweiten Zone eine Adresskonvertierungsstufe derart umfasst, dass alle Zugangsanfragen zur ersten Zone in Zugangsanfragen zur zweiten Zone konvertiert werden.
